# FASCICULE DE BREVET EUROPEEN

(11) **EP 0 944 851 B1**
(45) Date de publication et mention de la délivrance du brevet: **10.06.2009**
(21) Numéro de dépôt: 97951312.4
(22) Date de dépôt: 11.12.1997
(51) Int. Cl.: G02B 6/42, H01L 21/60, H01S 5/022

(54) **ASSEMBLAGE DE COMPOSANTS OPTIQUES ALIGNES OPTIQUEMENT ET PROCEDE DE FABRICATION DE CET ASSEMBLAGE**
OPTISCH AUSGERICHTETE ANORDNUNG VON OPTISCHEN KOMPONENTEN UND HERSTELLUNGSVERFAHREN FÜR DIESE ANORDNUNG
ASSEMBLY OF OPTICAL COMPONENTS OPTICALLY ALIGNED AND METHOD FOR MAKING THIS ASSEMBLY

(30) Priorité: 13.12.1996 FR 9615348
(43) Date de publication de la demande: 29.09.1999
(73) Titulaire: COMMISSARIAT A L'ENERGIE ATOMIQUE, 75015 Paris (FR)
(72) Inventeur: MASSIT, Claude, F-38330 Saint-Ismier (FR); MOTTIER, Patrick, F-38100 Grenoble (FR); MARION, François, F-38120 Saint-Egreve (FR)
(74) Mandataire: Audier, Philippe André
(86) Numéro de dépôt international: PCT/FR1997/002275
(87) Numéro de publication internationale: WO 1998/026318

(56) Documents cités:
- GB-A- 2 215 912
- US-A- 5 024 372
- PATENT ABSTRACTS OF JAPAN vol. 018, no. 349 (P-1763), 30 juin 1994 & JP 06 088917 A (NEC CORP), 29 mars 1994,
- IMLER W R: "PRECISION FLIP-CHIP SOLDER BUMP INTERCONNECTS FOR OPTICAL PACKAGING" IEEE TRANSACTIONS ON COMPONENTS,HYBRIDS,AND MANUFACTURING TECHNOLOGY, vol. 15, no. 6, 1 décembre 1992, pages 977-981, XP000364759
- WALE M ET AL: "FLIP-CHIP BONDING OPTIMIZES OPTO-ICS" IEEE CIRCUITS AND DEVICES MAGAZINE, vol. 8, no. 6, novembre 1992, pages 25-31, XP000441745
- TSUYOSHI HAYASHI: "AN INNOVATIVE BONDING TECHNIQUE FOR OPTICAL CHIPS USING SOLDER BUMPS THAT ELIMINATE CHIP POSITIONING ADJUSTMENTS" IEEE TRANSACTIONS ON COMPONENTS,HYBRIDS,AND MANUFACTURING TECHNOLOGY, vol. 15, no. 2, 1 avril 1992, pages 225-230, XP000307329 cité dans la demande

## Description

### DOMAINE TECHNIQUE

La présente invention concerne un assemblage de composants optiques alignés optiquement et un procédé de fabrication de cet assemblage.

L'invention trouve des applications dans le domaine de la micro-électronique et permet notamment de réaliser des modules optoélectroniques qui sont par exemple utilisables dans des gyromètres optiques et des multiplexeurs.

### ÉTAT DE LA TECHNIQUE ANTÉRIEURE

Dans le domaine de la micro-électronique, l'augmentation de la fréquence de fonctionnement des systèmes électroniques impose :
- la conception de nouveaux principes de transmission de données et notamment la mise en parallèle de bus électriques permettant de transmettre simultanément plusieurs signaux à la fois et/ou
- l'utilisation de la lumière grâce à des guides d'ondes optiques (guides d'ondes intégrés ou fibres optiques) afin d'augmenter le débit d'information.

Ces guides d'ondes optiques permettent d'obtenir une très bonne immunité aux perturbations électromagnétiques.

Dans le domaine des microsystèmes, l'apparition récente des microtechnologies laisse entrevoir des applications aux capteurs ou aux composants optiques dans le domaine de l'optique intégrée.

En effet, des dispositifs comme les gyromètres, les capteurs de vibrations, les capteurs chimiques, les têtes de lecture optique, les microcommutateurs, commencent à apparaître.

Ils nécessitent, comme dans le cas de dispositifs optoélectroniques destinés à des systèmes électroniques, une association de plusieurs types de composants : des composants optiques (guides d'ondes, réseaux de diffraction, ...), des composants optoélectroniques (diodes lasers, photodétecteurs, ...) et des composants électroniques (circuits intégrés en silicium ou en AsGa, ...).

La transmission optique nécessite la réalisation de modules d'émission, de réception et de traitement de signaux lumineux.

Pour cela des technologies sont développées en particulier sur verre ou silicium afin d'assurer :
- le couplage de fibres optiques
- les connexions optiques et électriques de composants optoélectroniques
- la connexion électrique de composants électroniques d'interface.

Des assemblages de composants optiques alignés optiquement sont déjà connus par les documents suivants auxquels on se reportera :
(1) K.P. Jackson et al., "A high-density, four channel, OEIC transceiver module utilizing planar-processed optical waveguides and flip-chip, solder bump technology", Journal of lightwave technology, vol.12, n°7, juillet 1994, p.1185 à 1191
(2) M.J. Wole et al., "A new self-aligned technique for the assembly of integrated optical devices with optical fibre and electrical interfaces", comptes rendus de ECOC 89, ThA19-7, p.368 à 371
(3) T. Hayashi, "An innovative bonding technique for optical chips using solder bump that eliminate chip positioning adjustments", IEEE Transactions on components, hybrids and manufacturing technology, vol.15, n°2, Avril 1992, p.225 à 230
(4) M. Yanagisawa et al., "Film-level hybrid integration of AlGaAs laser diode with glass waveguide on Si substrate", IEEE Photonics technology letters, vol.4, n°1, janvier 1992, p.21 à 23.

Ces assemblages connus se présentent en général sous la forme d'un substrat sur lequel :
- des fibres optiques sont connectées en regard de guides d'ondes optiques formés dans le substrat,
- des composants optoélectroniques sont emboîtés dans ce substrat et couplés à des guides d'ondes optiques,
- des composants électroniques adressent ou recueillent des informations venant de composants optiques.

Les composants optiques et optoélectroniques doivent être parfaitement alignés les uns par rapport aux autres pour minimiser les pertes optiques.

Les précisions visées peuvent être inférieure à 0,5 µm.

Pour ce faire, différents procédés sont utilisés.

On connaît un procédé d'alignement actif dont l'objectif est de s'assurer en temps réel de la performance d'alignement par une mesure électrique sur une photodiode d'un composant optoélectronique devant un guide d'onde.

Pour ce faire, le composant optoélectronique est alimenté et une mesure de la puissance lumineuse à la sortie de ce composant optoélectronique donne une indication sur l'alignement relatif des différents composants.

Une optimisation de l'alignement est assurée grâce à de faibles déplacements de l'élément à aligner au moyen de micromanipulateurs mécaniques ou piézo-électriques.

Un maintien peut être ensuite obtenu par collage.

Ce procédé d'alignement actif présente des inconvénients :
- longueur du processus d'alignement,
- nécessité d'un blocage mécanique, au moyen d'une colle par exemple, du composant après alignement et
- nécessité que ce blocage n'entraîne pas de contraintes mécaniques susceptibles de modifier l'alignement.

On connaît aussi un procédé d'alignement passif dont l'objectif principal est la réduction des coûts.

Cet alignement peut actuellement s'effectuer grâce à :
- de nouveaux types d'équipements très précis qui permettent de positionner des composants sur un support avec des précisions de l'ordre de 0,8 µm,
- des cales de positionnement réalisées dans le support et le composant à assembler (voir les documents (1) à (4)).

Les choix retenus pour le montage sont :
- l'usinage d'une cavité dans le support optique (voir le document (4))
- le positionnement du composant optique par un équipement de microassemblage ou par des cales et
- le soudage par thermo-compression ou brasure des plots de connexion (ou plages de contact) du composant optoélectronique sur le composant optique.

Ce procédé d'alignement passif présente des inconvénients :
- dans le cas des cales ou butées, il est difficile de réaliser des cales de positionnement à la fois dans le composant optique et dans le composant optoélectronique, et
- dans le cas de l'équipement de microassemblage, le temps de positionnement est très long du fait des précisions demandées (nécessité de réaliser une cavité dans le substrat et de maîtriser parfaitement la hauteur des bossages des plots d'interconnexion).

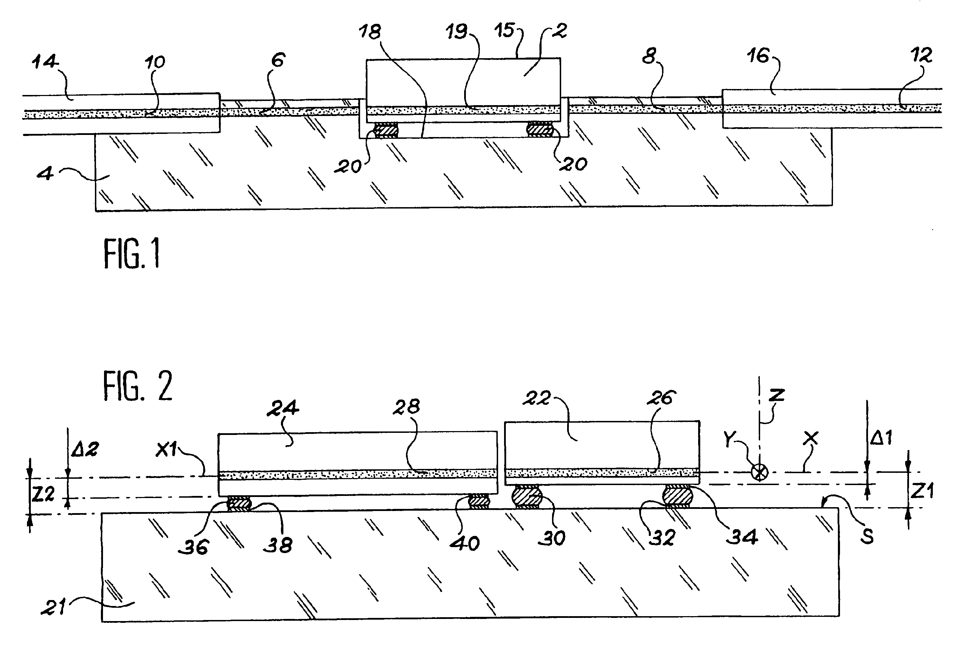

Un assemblage connu est schématiquement illustré par la figure 1 des dessins annexés.

Il s'agit de l'assemblage d'un composant optoélectronique 2 et d'un composant optique 4.

Ce composant optique 4 est un substrat pourvu de guides d'ondes optiques intégrés 6 et 8 dont des extrémités sont respectivement connectées aux coeurs 10 et 12 de fibres optiques 14 et 16.

Le composant optoélectronique 2 est disposé dans une cavité 18 formée dans le composant optique 4, de façon que les extrémités du ruban optique (« *optical stripe* ») 19 de ce composant 2 soient respectivement en regard des guides d'ondes 6 et 8.

Parallèlement au plan du substrat, l'alignement optique des composants 2 et 4 peut être obtenu par l'intermédiaire d'une machine de positionnement de haute précision et, perpendiculairement à ce plan, par des bossages 20 (éléments de soudure) de hauteur calibrée.

Cet alignement peut aussi être obtenu, au cours de l'assemblage, par une mesure optique ou électrique du couplage entre le composant optoélectronique et le composant optique.

Les connexions électriques (non représentées) du composant optoélectronique se situent au fond de la cavité 18 et utilisent les éléments de soudure 20.

L'obtention de cet assemblage connu nécessite la maîtrise des tolérances dimensionnelles des éléments :
- profondeurs de la cavité,
- hauteur des bossages,
- épaisseur des métallisations nécessaires aux connexions électriques, et
- distance du ruban optique 19 du composant optoélectronique 2 à la surface 15 de ce composant 2.

Patent abstracts of Japan, volume 18, numéro 349, 30/6/1994, divulgue un procédé de connexion d'un guide d'onde optique et de l'extrémité d'une fibre optique. Selon ce procédé, on forme des boules de brasure sur des plots métalliques qui sont prévus sur un support. D'autres plots métalliques prévus sur le guide d'onde optique et sur la surface latérale de l'extrémité de la fibre optique sont connectés de telle manière qu'une partie de ces plots soit en contact avec les boules de brasure.

GB 2 215 912 A décrit une technique de vérification du positionnement de liaisons de soudure entre un substrat et un composant optique.

US 5 024 372 A décrit la formation d'éléments de soudure cylindriques sur un substrat par photolithographie. Ces éléments ont tous le même diamètre.

### EXPOSÉ DE L'INVENTION

La présente invention a pour but de définir une structure permettant d'atteindre un alignement passif très précis de composants optiques sans utiliser de cale ni de cavité.

Pour cela, les auteurs de l'invention ont développé une structure basée sur l'assemblage de composants optiques à partir d'un substrat d'interconnexion et de la technologie d'interconnexion de composants électronique par microbilles.

Ces microbilles sont réalisées à partir d'un métal fusible en particulier de type Indium ou d'un alliage fusible à base d'étain/plomb.

Les microbilles étant situées sur le substrat d'interconnexion, le montage des composants peut être effectué en une seule et même opération.

L'alignement optique des composants parallèlement au plan du substrat est assuré par les forces de tension de surface des microbilles de soudure (technologie connue par les documents (2) et (3)).

En hauteur, c'est-à-dire perpendiculairement à ce plan, l'alignement optique est contrôlé par les volumes relatif des microbilles.

En effet, grâce à cette structure, la précision d'alignement des composants est très importante car elle devient une précision relative et non plus absolue.

Les nombreux avantages de l'invention sont indiqués ci-après.
1) Il n'est pas nécessaire d'aligner de façon précise les composants parallèlement au plan du substrat.

En effet, un auto-alignement des composants a lieu du fait que l'on utilise la technologie des microbilles.

L'erreur sur un tel auto-alignement est inférieure à 1 µm.

En effet, lors de la refusion du matériau fusible constituant les microbilles, les forces de tension superficielle de ce matériau en fusion et les forces de mouillabilité de celui-ci sur ses plots métalliques d'accrochage permettent d'obtenir un auto-alignement des composants sur le substrat qui les reçoit.

L'axe de chaque plot d'accrochage situé sur le substrat se confond avec l'axe du plot correspondant situé sur le composant que l'on veut positionner.

La précision d'alignement des composants les uns par rapport aux autres, dans un plan parallèle au substrat, dépend uniquement de la précision d'alignement des plots d'accrochage des microbilles du côté des composants optiques par rapport aux axes optiques.

L'alignement de ces plots est, de préférence, obtenu par photolithographie de sorte que l'erreur résultante peut être facilement rendue inférieure à 0,3 µm avec les équipements utilisés en micro-électronique.

Du côté du substrat, les plots qui reçoivent les microbilles de tous les composants optiques sont, de préférence, formés simultanément de sorte que l'erreur relative entre plots est quasiment nulle (en négligeant les dilatations thermiques).

Autrement dit, ces plots sont auto-alignés.
2) La précision d'alignement vertical (alignement perpendiculairement au plan du substrat) des différents composants les uns par rapport aux autres est très bonne car il s'agit d'une précision relative entre chaque composant et le substrat d'interconnexion alors que, dans le cas de la figure 1, la précision est nécessairement absolue entre le composant optoélectronique 2 et les guides d'ondes 6 et 8.

Cette remarque est très importante car, grâce à la présente invention, il n'est plus nécessaire de maîtriser parfaitement le volume des microbilles pour aligner verticalement les composants entre eux.

En effet, les microbilles étant situées sur le substrat d'interconnexion, leurs volumes sont calculés de telle manière qu'après hybridation, les distances des axes optiques des composants soient identiques par rapport à la surface du substrat d'interconnexion.

Ces microbilles sont réalisées en général à partir de disques cylindriques dont les volumes sont calculés pour être respectivement égaux aux volumes souhaités des microbilles.

Le volume des disques doit être légèrement supérieur à celui des microbilles lorsque la fusion se fait sous flux

Le contrôle de ces volumes passe par le contrôle des diamètres D et des épaisseurs E des disques.

Lorsque le paramètre D résulte d'une photolithographie, l'erreur engendrée par ce paramètre D est négligeable.

L'épaisseur E de matériau déposé est alors le paramètre à contrôler.

L'erreur relative ΔV/V sur le volume V d'une microbille est alors égale à l'erreur relative ΔE/E sur l'épaisseur E.

Par contre, une fluctuation positive ou négative de l'épaisseur. E par rapport à sa valeur nominale, entraîne une fluctuation dans le même sens, par rapport au substrat d'interconnexion, de tous les composants hybridés.

Le mouvement relatif est très faible, ce qui garantit ainsi le bon alignement relatif des composants entre eux.
3) Les microbilles étant réalisées simultanément sur le substrat d'interconnexion et l'épaisseur du matériau fusible déposé étant sensiblement constante, les volumes respectivement souhaités pour les microbilles sont atteints par des diamètres adaptés des disques.
4) Les connexions électriques entre les composants optoélectroniques ou électroniques et les plots d'interconnexion peuvent être réalisées sur un substrat plan et non plus dans des cavités comme dans le cas de la figure 1.
5) Toutes les cales d'alignement usinées dans ou sur chaque composant optique sont supprimées.

De façon précise, la présente invention a tout d'abord pour objet un assemblage d'une pluralité de composants optiques sur un support, conformément à la revendication 1.

Ainsi on peut jouer sur la taille du deuxième plot pour obtenir le volume de bossage désiré.

L'alignement optique des composants suivant une direction contenue dans un plan parallèle à la surface du support est obtenu automatiquement par les forces de tension des bossages en fusion.

Par « composant optique », on entend aussi bien un compostant purement optique qu'un composant optoélectronique.

Selon un mode de réalisation particulier de l'assemblage objet de l'invention, au moins l'un des composants optiques est un composant optoélectronique et le support comprend en outre des lignes électriques qui sont électriquement connectées au composant optoélectronique par l'intermédiaire des bossages correspondants.

Dans ce cas, lesdits bossages et les plots correspondants doivent être conducteurs électriques.

Ces lignes peuvent être intégrées au support ou formées à la surface de ce support.

La présente invention a aussi pour objet un procédé d'obtention d'un assemblage d'une pluralité de composants optiques sur un support, conformément à la revendication 5.

L'alignement optique des composants suivant une direction contenue dans un plan parallèle à la surface du support est obtenu automatiquement par les forces de tension des éléments en fusion.

Selon un mode de mise en oeuvre préféré du procédé objet de l'invention, les éléments formés sur les deuxièmes plots sont sensiblement cylindriques et ont tous la même épaisseur.

Selon un mode de mise en oeuvre particulier du procédé objet de l'invention, on fait passer à l'état fondu les éléments formés sur les deuxièmes plots, chaque élément prenant alors sensiblement la forme d'une bille, on fait ensuite passer ces éléments en forme de bille à l'état solide et l'on fait passer ces derniers à l'état fondu pour assembler les composants au support.

La forme de la bille dépend de la forme du plot et n'est donc pas forcément sphérique.

De façon avantageuse, pour avoir la même précision sur la hauteur des différents billes, les éléments sensiblement cylindriques sont formés simultanément par photolithographie sur les deuxièmes plots.

Le matériau des éléments peut être choisi dans le groupe comprenant l'indium et l'alliage étain-plomb, par exemple.

Selon un mode de mise en oeuvre particulier de l'invention, au moins l'un des composants est opto-électronique, les plots et les éléments correspondants étant conducteurs électriques, et l'on forme en outre sur le support des lignes électriques destinées à être électriquement connectées au composant opto-électronique par l'intermédiaire des éléments correspondants.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- la figure 1, déjà décrite, est une vue schématique d'un assemblage connu de composants optiques,
- la figure 2 est une vue schématique d'un assemblage de composants optiques réalisé conformément à la présente invention,
- les figures 3A, 3B et 3C illustrent schématiquement un élément de soudure cylindrique (figure 3A) qui, par fusion, devient une microbille (figure 3B), celle-ci servant à la connexion d'un composant optique (figure 3c).
- La figure 4 illustre schématiquement un autre assemblage conforme à l'invention, et
- les figures 5A à 5E illustrent schématiquement diverses étapes d'un procédé conforme à l'invention.

### EXPOSÉ DÉTAILLÉ DE MODES DE RÉALISATION PARTICULIERS

Pour simplifier la description, les exemples donnés concernent un substrat plan, étant bien entendu que l'invention peut s'appliquer à des substrats présentant une surface non plane, les volumes des bossages étant déterminés de façon à tenir compte de la topologie des substrats.

La figure 2 illustre schématiquement un assemblage conforme à l'invention de deux composants optiques sur un substrat ou support d'interconnexion 21 dont la surface S est plane.

L'un de ces composants a pour référence 22 et comprend un guide d'onde 26 dont l'axe optique est l'axe X.

L'autre composant a pour référence 24 et comprend aussi un guide d'onde 28 dont l'axe optique est l'axe X1.

Les axes X et X1 sont parallèles à la surface S du substrat 21.

On considère un autre axe Y qui est également parallèle à cette surface S et qui est de plus perpendiculaire à l'axe X de sorte que le plan XY est parallèle à la surface S.

On considère également un axe Z perpendiculaire à cette surface S.

On doit avoir un alignement optique « vertical » des composants 22 et 24 c'est-à-dire un alignement suivant la direction Z.

En d'autres termes, l'axe X1 doit être contenu dans le plan XY.

De plus, on doit avoir un alignement optique « horizontal » des composants 22 et 24 c'est-à-dire un alignement suivant une direction contenue dans un plan parallèle à la surface S du substrat 21.

En d'autres termes, l'axe X1 doit être confondu avec l'axe X.

Le composant 22 est fixé à la surface plane S du substrat 21 par l'intermédiaire d'éléments de soudure ou microbilles 30.

Cette surface S est munie de plots d'accrochage 32.

Le composant 22 est muni d'autres plots d'accrochage 34 correspondant respectivement aux plots 32 et chaque microbille 30 est fixée d'un côté à un plot 32 et de l'autre côté à un plot 34.

De même, le composant 24 est fixé à la surface plane S du substrat 21 par l'intermédiaire d'éléments de soudure ou microbilles 36.

Cette surface S est munie de plots d'accrochage 38.

Le composant 24 est muni d'autres plots d'accrochage 40 correspondant respectivement aux plots 38 et chaque microbille 36 est fixée d'un côté à un plot 38 et de l'autre côté à un plot 40 comme on le voit sur la figure 2.

On connaît la distance Δ1 de l'axe X à la face du composant 22 qui est située en regard de la surface plane S du substrat 21.

On connaît également la distance Δ2 de l'axe X1 à la face du composant 24 qui est située en regard de cette surface plane S.

Dans ces conditions, on calcule les volumes V1 des microbilles 30 et les volumes V2 des microbilles 36 de façon que la distance Z1 de l'axe X à la surface plane S soit égale à la distance Z2 de l'axe X1 à cette surface plane.

En ce qui concerne l'obtention des microbilles 30 et 36, une légère variation (erreur) négative (respectivement positive) de V1 entraîne une variation (erreur) négative (respectivement positive) de V2 et donc une diminution (respectivement une augmentation) simultanée de Z1 et Z2, ce qui permet de minimiser l'erreur relative entre Z1 et Z2.

Les microbilles assurent naturellement l'alignement des composants 22 et 24 l'un par rapport à l'autre mais peuvent également assurer l'interconnexion électrique de l'un de ces composants lorsqu'il s'agit d'un composant optoélectronique.

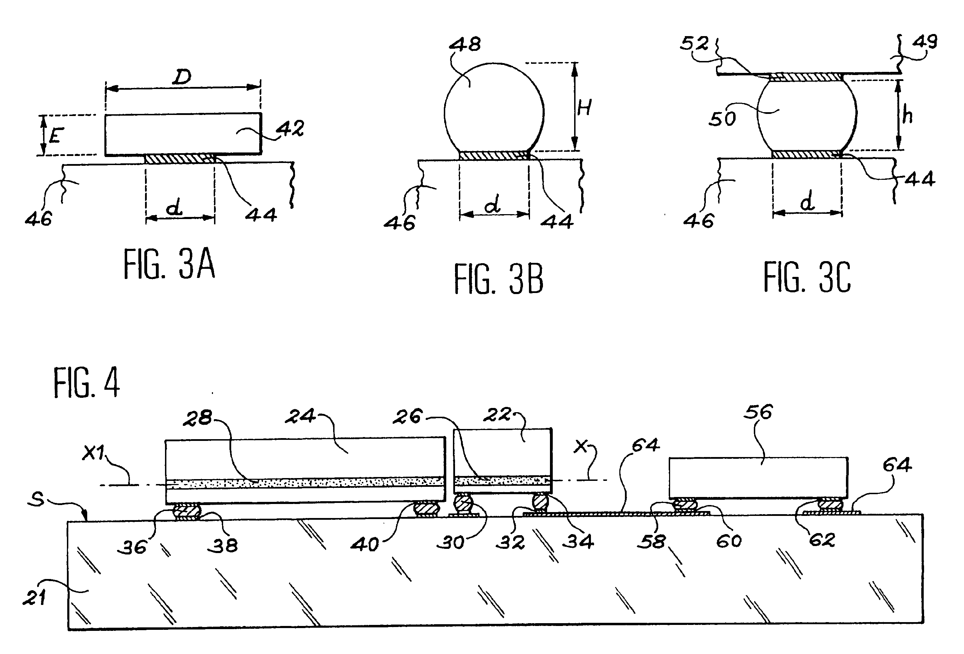

La figure 3A représente schématiquement un disque de soudure 42 de diamètre D et d'épaisseur E, qui est disposé sur un plot 44 d'interconnexion métallique en forme de disque de diamètre d, lui-même formé sur la surface plane d'un substrat d'interconnexion 46.

Le disque 42 est destiné à former une microbille servant à fixer un composant optique sur le substrat 46.

Le volume du disque 42 est noté V.

Le diamètre d du plot 44 est adapté à ce volume V qui est également le volume de la microbille formée à partir du disque 42 car il y a conservation du volume au cours de la formation de cette microbille.

La figure 3B montre cette microbille référencée 48 qui se forme sur le plot d'accrochage 44 lorsque le disque 42 est chauffé au-delà de sa température de fusion.

La microbille 48 (de volume V) a sensiblement la forme d'une sphère tronquée (d'un seul côté) et a une hauteur notée H.

La figure 3C montre schématiquement la liaison entre un composant optique 49, muni d'un plot d'accrochage 52, et la surface du substrat 46 par l'intermédiaire d'une microbille référencée 50 qui relie les plots 44 et 52.

Cette microbille 50 (de volume V) a sensiblement la forme d'une sphère tronquée des deux côtés et a une hauteur notée h.

La microbille 50 résulte d'une refusion de la microbille 48 de la figure 3B.

Le disque de soudure 42 est de préférence formé par une technologie de dépôt électrolytique à travers une résine photosensible.

Dans ce cas, le volume V est égal au produit de la surface d'ouverture dans la résine par la hauteur du métal de soudure qui est déposé dans cette ouverture.

De préférence, dans la présente invention, les microbilles situées sur le substrat d'interconnexion sont réalisées à partir d'une épaisseur constante de dépôt de matériau fusible par cette technologie de dépôt électrolytique à travers une résine photosensible.

Les volumes respectifs des microbilles sont alors ajustés à partir des ouvertures dans la résine.

L'erreur commise sur une ouverture (de diamètre D) est généralement très faible du fait de l'utilisation d'une lithographie.

De plus, l'erreur commise sur le diamètre d du plot d'accrochage 44 est également très faible si l'on utilise également un masquage et une gravure contrôlée pour la fabrication d'un tel plot.

L'erreur sur le volume V est donc proportionnelle à l'erreur commise sur l'épaisseur E du matériau fusible qui a été déposé.

Pour toute les microbilles, quels que soient leurs volumes respectifs, cette erreur a donc le même sens de fluctuation que celui de l'épaisseur E déposée.

L'erreur ΔV/V sur le volume V est égale à l'erreur ΔE/E sur cette épaisseur E.

Les auteurs de la présente invention ont vérifiés par calcul et expérimentalement que le fait de passer d'un disque (figure 3A) à une calotte sphérique (figure 3B et figure 3C) permet de diminuer l'erreur relative ΔH/H sur la hauteur H et l'erreur relative Δh/h sur la hauteur h par rapport à l'épaisseur E.

En d'autres termes, l'erreur relative ΔH/H est inférieure à ΔE/E.

De même, l'erreur relative Δh/h est inférieure ΔE/E.

Ceci est mis à profit pour diminuer l'incertitude sur la hauteur des composants optiques après hybridation et donc de réduire encore l'erreur de positionnement relatif entre ces composants optiques.

La figure 4 montre encore l'alignement optique des composants optiques 22 et 24 de la figure 2 sur le substrat 21.

Dans l'exemple de la figure 4, le composant 22 est une diode laser et le composant 24 est un diviseur.

On a en plus fixé sur la surface plane S du substrat 21 un circuit électronique de commande 56 également par l'intermédiaire de microbilles de soudure 58.

Chaque microbille est fixée d'un côté à un plot d'accrochage 60 situé sur la surface plane S et de l'autre côté à un autre plot d'accrochage 62 situé sur la face du circuit 56 qui se trouve en regard de cette surface plane S.

Ce circuit électronique 56 peut être assemblé par les technologies standard d'interconnexion des composants électroniques.

Seul le composant purement optique 24 et le composant optoélectronique 22 nécessitent un alignement optique précis.

On voit également sur la figure 4 diverses pistes d'interconnexion 64 destinées aux interconnexions électriques des composants qui nécessitent de telles interconnexions, par l'intermédiaire des microbilles (qui sont conductrices).

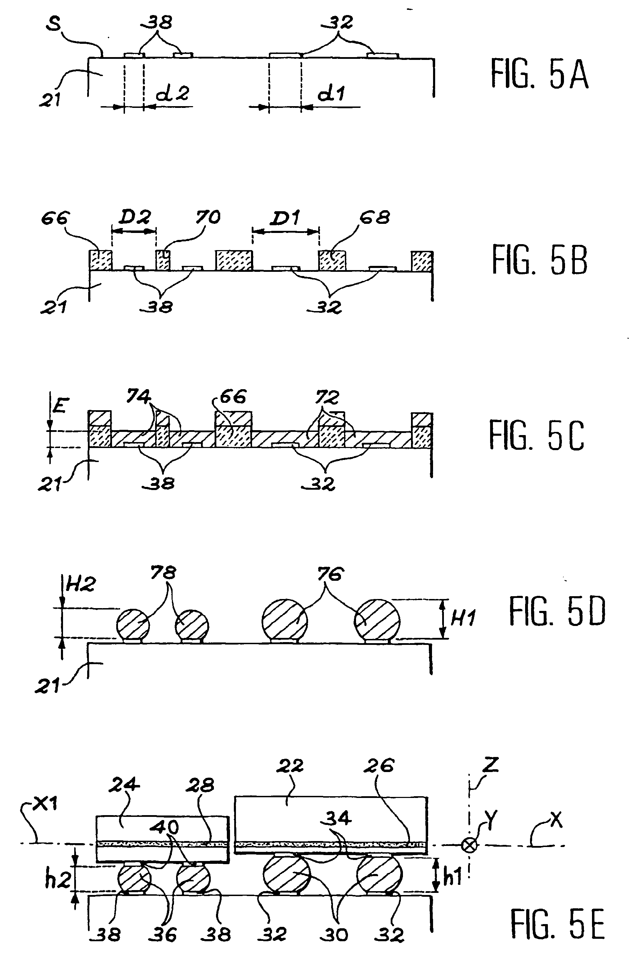

Les figures 5A, 5B, 5C, 5D et 5E illustrent schématiquement diverses étapes d'un procédé d'assemblage de composants optiques conformément à l'invention.

Il s'agit des deux composants optiques 22 et 24 de la figure 2 que l'on cherche a aligner optiquement sur la surface plane S du support 21.

Comme on l'a vu plus haut, le composant 22 est fixé à la surface plane du substrat 21 par l'intermédiaire de microbilles de soudure 30.

Chaque microbille 30 est fixée d'un côté à un plot d'accrochage 32 formé sur la surface plane du substrat 21 et de l'autre côté à un autre plot d'accrochage 34 dont est pourvue la surface du composant 22 qui se trouve en regard de cette surface du substrat 21.

De même, chaque microbille de soudure 36 du composant 24 est fixée d'un côté à un plot d'accrochage 38 formé sur la surface plane de substrat 21 et de l'autre côté à un autre plot d'accrochage 40 formé sur la surface du composant 24 qui est située en regard de cette surface plane du substrat 21.

Bien entendu, chacun des plots 32, 34, 38 et 40 est mouillable par le matériau constitutif des microbilles 30 et 36 tandis que l'environnement de ces plots ne l'est pas.

On commence (figure 5A) par former, sur la surface plane S du substrat 21 les plots d'accrochage 32 et 38 des diverses microbilles qui seront ultérieurement formées.

Pour ce faire, on peut utiliser un dépôt métallique « pleine tranche » par pulvérisation cathodique de type TiNiAu suivi d'une étape de photolithographie et d'une étape de gravure.

Ces plots d'accrochage peuvent avoir une forme quelconque, par exemple une forme circulaire, hexagonale, octogonale ou carrée et même rectangulaire.

De ce fait, les microbilles ne sont pas forcément sphériques.

Dans l'exemple représenté, ces plots sont des disques de diamètre d1 pour les plots 32 et des disques de diamètre d2 pour les plots 38.

Les dimensions de ces plots (les diamètres d1 et d2 dans l'exemple représenté), comptées parallèlement à la surface du substrat 21, sont déterminées à partir des hauteurs désirées pour les microbilles.

De plus, on peut prévoir des lignes d'interconnexion électriques, qui sont intégrées au substrat 21 ou situées à la surface de celui-ci, pour alimenter électriquement (par l'intermédiaire des microbilles ultérieurement formées) les composants qui le nécessitent.

De façon avantageuse, dans le cas où ces lignes d'interconnexion (non représentées) sont disposées à la surface du substrat 21, pour maintenir une hauteur identique de tous les plots d'accrochage des microbilles, une surface délimitée du matériau utilisé pour ces interconnexions électriques peut être déposée sous les plots d'accrochage qui ne sont pas connectés électriquement.

Ensuite (figure 5B), une étape de lithographie permet de définir les volumes des microbilles à partir des diamètres D1 et D2 et de l'épaisseur E que l'on choisit pour les disques de matériau fusible.

On dépose une couche de résine photosensible 66 sur la surface plane du substrat 21 et on insole cette résine pour y définir des ouvertures circulaires 68 de diamètre D1, correspondant au composant 22, et d'autres ouvertures circulaires 70 de diamètre D2, correspondant au composant 24.

Ensuite, (figure 5C), on dépose par évaporation le matériau fusible destiné à la formation ultérieure des microbilles, à travers les ouvertures 68 et 70 ainsi obtenues jusqu'à ce que l'on obtienne une épaisseur E de matériau fusible dans les ouvertures et sur la couche de résine.

Comme on le voit sur la figure 5C, on obtient ainsi des disques de soudure 72 de diamètre D1 et des disques de soudure 74 de diamètre D2 respectivement formés au-dessus des plots 32 et 38.

Connaissant l'épaisseur E commune à tous les disques 72 et 74, les diamètres respectifs d1 et d2 des plots 32 et 38 et les hauteurs respectives h1 et h2 des microbilles 30 et 36 que l'on veut former, on en déduit les diamètres D1 et D2 des ouvertures que l'on doit former dans la couche de résine 66.

Après avoir formé les disques de soudure 72 et 74, on élimine la couche de résine 66 par "lift off".

Le matériau fusible déposé sur ladite couche est ainsi éliminé.

Ensuite (figure 5D), on élève la température du substrat 21 au-dessus de la température de fusion du matériau constitutif des disques 72 et 74 et l'on obtient ainsi des microbilles 76 correspondant au composant 22 et des microbilles 78 correspondant au composant 24, ces microbilles étant respectivement accrochées aux plots 32 et 38.

On a noté sur la figure 5D la hauteur H1 des microbilles 76 et la hauteur H2 des microbilles 78.

On procède ensuite (figure 5E), à l'hybridation des composants optiques 22 et 24.

Pour ce faire, on positionne convenablement ces composants 22 et 24 respectivement sur les microbilles 30 et 36 de façon que les plots d'accrochage 34 et 40 de ces composants reposent respectivement sur les microbilles correspondantes.

Puis l'on élève la température des microbilles au-delà de leur température de fusion.

L'alignement optique des composants 22 et 24 (coïncidence des axes optiques X et X1) est alors assuré automatiquement.

Dans le plan XY qui est parallèle à la surface plane S du substrat 21, l'alignement résulte des forces de tension de surface du matériau fusible.

Suivant l'axe Z, cet alignement est obtenu par les volumes adaptés des microbilles qui permettent de compenser les différences de distances entre les axes optiques des composants et la surface de ces derniers sur laquelle sont réalisés les plots d'accrochage des microbilles.

L'étape de fusion illustrée par la figure 5D n'est pas indispensable.

On peut procéder à l'hybridation des composants 22 et 24 au moyen des disques 72 et 74 sur lesquels on positionne-convenablement les composants 22 et 24.

Ensuite on élève la température des disques au-delà de leur température du fusion.

On aboutit alors au schéma de la figure 5E.

On laisse ensuite refroidir la soudure jusqu'à la température ambiante d'où l'hybridation des composants sur le substrat.

## Revendications

1. Assemblage d'au moins deux composants optiques (22, 24), fixés sur une même face d'un support commun (21), les composants optiques (22, 24) ayant chacun un axe optique (X, X1) et une face principale parallèle audit axe et séparée de celui-ci par une distance donnée, cette distance présentant une valeur différente pour un premier au moins des composants optiques par rapport à celle des autres composants optiques, l'assemblage étant tel que les axes optiques (X, X1) des composants optiques (22, 24) soient optiquement alignés, les faces principales des composants optiques (22, 24) s'étendant en regard de ladite face du support commun (21), ledit assemblage comprenant des premiers plots d'accrochage (34, 40) formés sur la face principale de chaque composant optique (22, 24), des deuxièmes plots d'accrochage (32, 38) formés sur ladite face du support commun (21) et correspondant respectivement aux premiers plots (34, 40), et des éléments en forme de billes (30, 36) faits d'un matériau fusible reliant chaque premier plot (34, 40) à un deuxième plot (32,38), le matériau fusible pouvant mouiller les premiers et deuxième plots et y être soudé, mais ne pouvant pas mouiller l'environnement des premiers et deuxièmes plots, l'alignement des axes optiques (X, X1) des composants optiques (22, 24) étant obtenu par le fait que les éléments en forme de billes (30, 36) correspondant respectivement à ces composants présentent des hauteurs différentes, déterminées de façon à compenser les valeurs différentes de ladite distance, ces hauteurs différentes des éléments en forme de billes étant obtenues par la sélection de différences de volumes adéquats pour les éléments en forme de billes (30, 36) correspondants, **caractérisé en ce que** les hauteurs différentes des éléments en forme de billes sont également obtenues par la mise en oeuvre de deuxièmes plots d'accrochage (32, 38) de tailles différentes, déterminées de façon à compenser les valeurs différentes de ladite distance, pour obtenir des éléments en forme de billes de hauteurs différentes, assurant l'alignement des axes optique (X, X1) des composants.

2. Assemblage selon la revendication 1, **caractérisé en ce que** au moins l'un des composants optiques est un composant optoélectronique (22) et **en ce que** le support (21) comprend en outre des lignes électriques (64) qui sont électriquement connectées au composant optoélectronique par l'intermédiaire des bossages (30) correspondants, lesdits éléments en forme de billes et les plots correspondants étant électriquement conducteurs.

3. Assemblage selon la revendication 2, ***caractérisé* en ce que** ces lignes sont intégrées au support (21).

4. Assemblage selon la revendication 2, **caractérisé en ce que** ces lignes sont formées à la surface (S) du support.

5. Procédé d'obtention d'un assemblage d'au moins deux composants optiques (22, 24) fixés sur une même face d'un support commun (21), les composants optiques ayant chacun un axe optique (X, X1) et une face principale parallèle audit axe et séparée de celui-ci par un distance donnée, cette distance présentant une valeur différente pour un premier au moins des composants optiques par rapport à celle des autres composants optiques, l'assemblage étant tel que les axes optiques des composants optiques soient optiquement alignés, procédé dans lequel :
• on forme des premiers plots d'accrochage (34, 40) sur la face principale de chaque composant optique (22, 24) et on forme des deuxièmes plots d'accrochage (32, 38) sur ladite face du support commun (21),
• on forme des éléments (72, 74) faits d'un matériau fusible sur les deuxièmes plots (32, 38), le matériau fusible pouvant mouiller les premiers et deuxièmes plots et y être soudé, mais ne pouvant pas mouiller l'environnement des premiers et deuxièmes plots,
• on fixe les composants, optiques (22, 24) sur le support (21) en faisant fondre les éléments (72, 74) formés sur les deuxièmes plots (32, 38), pour leur donner la forme de billes (76, 78), puis en faisant passer ces derniers à l'état solide, pour relier chaque deuxième plot (32, 38) à un premier plot (34, 40) par l'intermédiaire d'un élément en forme de bille (30, 36),
et dans lequel, lors de la formation des éléments (72, 74) sur les deuxièmes plots (32, 38), les volumes des éléments formés sur les deuxièmes plots correspondant à chacun des composants sont choisis de façon à compenser les différences entre les valeurs desdites distances d'un composant à l'autre, afin de contribuer automatiquement à l'alignement des axes optiques (X, X1) des composants optiques lors de leur fixation sur le support, procédé ***caractérisé en ce que*** l'on forme les deuxièmes plots d'accrochage (32, 38) sur ladite face du support commun (21) en donnant à ces deuxièmes plots des tailles contribuant à compenser les différences entre lesdites distances d'un composant à l'autre, les différences de tailles des deuxièmes plots (32, 38) et des éléments (72, 74) formés dessus étant déterminées pour fixer les composants optiques (22, 24) sur le support (21) par l'intermédiaire d'éléments en forme de billes (30, 36) de hauteurs différentes, assurant l'alignement optique des composants.

6. Procédé selon la revendication 5, ***caractérisé en ce que*** les éléments (72, 74) formés sur les deuxièmes plots (32, 38) sont sensiblement cylindriques et ont tous la même épaisseur.

7. Procédé selon la revendication 6, ***caractérisé en ce que*** les éléments sensiblement cylindriques (72, 74) sont formés simultanément par photolithographie sur les deuxièmes plots.

8. Procédé selon l'une quelconque des revendications 5 à 7, ***caractérisé en ce que*** le matériau des éléments (72, 74) est choisi dans le groupe comprenant l'indium et l'alliage étain-plomb.

9. Procédé selon l'une quelconque des revendications 5 à 8, **caractérisé en ce que** au moins l'un (22) des composants est opto-électronique, les plots et les éléments correspondants étant conducteurs électriques, et **en ce que** l'on forme en outre sur le support (21) des lignes électriques (64) destinées à être électriquement connectées au composant opto-électronique par l'intermédiaire des éléments en forme de billes correspondants (30).

## Claims

1. Assembly of at least two optical components (22, 24) which are fixed on a same face of a common support (21), the optical components (22, 24) each having an optical axis (X, X1) and a main face which is parallel to said axis and separated therefrom by a given distance, the distance having a different value for at least a first one of the optical components with respect to that of the other optical components, the assembly being such that the optical axes (X, X1) of the optical components (22, 24) are optically aligned, the main faces of the optical components (22, 24) extending facing said face of the common support (21), said assembly comprising first fastening studs (34, 40) formed on the main face of each optical components (22, 24), second fastening studs (32, 38) that are formed on the said face of the common support (21) and correspond respectively to the first studs (34, 40), and ball-shaped elements (30, 36) made of a meltable material connecting each first stud (34, 40) to a second stud (32, 38), the meltable material being able to wet the first and second studs and to be soldered thereto, but not being able to wet the area surrounding the first and second studs, the alignment of the optical axes (X, X1) of the optical components (22, 24) being obtained by the fact that the ball-shaped elements (30, 36) respectively corresponding to those components have different heights which are determined so as to compensate for the different values of said distance, these different heights of the ball-shaped elements being obtained by selecting differences of appropriate volumes for the corresponding ball-shaped elements (30, 36), **characterized in that** the different heights of the ball-shaped elements are also obtained by implementing second fastening studs (32, 38) having different sizes which are determined so as to compensate for the different values of said distance, in order to obtain ball-shaped elements having different heights which ensure the alignment of the optical axes (X, X1) of the components.

2. Assembly of claim 1 **characterized in that** at least one of the optical components is an optoelectronic component (22) and **in that** the support (21) also comprises electric lines (64) that are electrically connected to the optoelectronic component using the corresponding bumps (30), said ball-shaped elements and the corresponding studs being electrically conductive.

3. Assembly of claim 2, **characterized in that** these lines are integrated into the support (21).

4. Assembly of claim 2, **characterized in that** these lines are formed on the surface (S) of the support.

5. Process for obtaining an assembly of at least two optical components (22, 24) which are fixed on a same face of a common support (21), the optical components (22, 24) each having optical axis (X, X1) and a main face which is parallel to said axis and separated therefrom by a given distance, the distance having a different value for at least a first one of the optical components with respect to that of the other optical components, the assembly being such that the optical axes (X, X1) of the optical components (22, 24) are optically aligned, process wherein :
• first fastening studs (34, 40) are formed on the main face of each optical component (22, 24) and second fastening studs (32, 38) are formed on the said face of the common support (21),
• elements (72, 74) are formed on the second studs (32, 38), these elements being made of a meltable material, the meltable material being able to wet the first and seconds studs and to be soldered thereto, but not being able to wet the area surrounding the first and second studs,
• the optical components (22, 24) are fixed on the support (21) by melting the elements (72, 74) which are formed on the second studs (32, 38), so as to give them the shape of balls (76, 78), then by making the latter pass to the stolid state, so as to connect each second stud (32, 38) to a first stud (34, 40) using a ball-shaped element (30, 36),
and wherein, when forking the elements (72, 74) on the second studs (32, 38), the volumes of the elements which are formed on the second studs corresponding to each of the components are chosen so as to compensate for the differences between the values of said distances from one component to another one, so as to automatically contribute to the alignment of the optical axes (X, X1) of the optical components when they are fixed on the support, **characterized in that** the second fastening studs (32, 38) are formed on the said face of the common support (21) by giving to these second studs sizes which contribute to compensating for the differences between the said distances from one component to the other, the differences of sizes of the second studs (32, 38) and of the elements (72, 74) which are formed thereon being determined so as to fix the optical components (22, 24) on the support (21) using ball-shaped elements (30, 36) having different heights, ensuring the optical alignment of the components.

6. Process of claim 5, **characterized in that** the elements (72, 74) that are formed on the second studs (32, 38) are substantially cylindrical in shape and all have the same thickness.

7. Process of claim 6, **characterized in that** the elements, that are substantially cylindrical in shape (72, 74), are formed simultaneously on the second studs using photolithography.

8. Process of any of the claims 5 to 7, **characterized in that** the material of the elements (72, 74) is chosen from the groupe that comprises indium and the tin-lead alloy.

9. Process of any of claims 5 to 8, **characterized in that** at least one (22) of the components is optoelectronic, the studs and the corresponding elements being electric conductors, and **in that** electric lines (64) are also formed on the support (21) and are intended to be electrically connected to the optoelectronic component using the corresponding ball-shaped elements (30).

## Patentansprüche

1. Anordnung von wenigstens zwei optischen Komponenten (22, 24), befestigt auf derselben Seite eines gemeinsamen Trägers (21), wobei jede der optischen Komponenten (22, 24) eine optische Achse (X, X1) hat und eine Hauptseite, die zu der genannten Achse parallel ist und von ihr durch einen bestimmten Abstand getrennt ist, wobei dieser Abstand für wenigstens eine erste der optischen Komponenten einen Wert aufweist, der sich von dem der anderen optischen Komponenten unterscheiden, und die Anordnung dabei so ist, dass die optischen Achsen (X, X1) der optischen Komponenten (22, 24) optisch ausgerichtet sind und die Hauptseiten der optischen Komponenten (22, 24) sich gegenüber der genannten Seite des gemeinsamen Trägers (21) erstrecken, wobei die genannte Anordnung erste Befestigungselemente (34, 40), ausgebildet auf der Hauptseite jeder optischen Komponente (22, 24), zweite Befestigungseinrichtungen (32, 38), ausgebildet auf der genannten Seite des gemeinsamen Trägers (21) und jeweils den ersten Befestigungseinrichtungen (34, 40) entsprechend, und kugelförmige Elemente (30, 36) umfasst, die aus einem schmelzbaren Material sind und jedes erste Element (34, 36) mit einem zweiten Element (32, 38) verbinden, wobei das schmelzbare Material die ersten und zweiten Befestigungseinrichtungen benetzen und mit ihnen eine Lötverbindung eingehen kann, aber die Umgebung der ersten und zweiten Befestigungseinrichtungen nicht benetzen kann, und die Ausrichtung bzw. Flucht der optischen Achsen (X, X1) der optischen Komponenten (22, 24) **dadurch** erhalten wird, dass die diesen Komponenten jeweils entsprechenden kugelförmigen Elemente (30, 36) verschiedene Höhen aufweisen, so festgelegt, dass die verschiedenen Werte des genannten Abstands kompensiert werden, wobei man diese verschiedenen Höhen der kugelförmigen Elemente durch die Selektion adäquater Volumendifferenzen für die entsprechenden kugelförmigen Elemente (30, 36) erhält,
**dadurch gekennzeichnet, dass** man die verschiedenen Höhen der kugelförmigen Elemente ebenfalls **dadurch** erhält, dass man für die zweiten Befestigungseinrichtungen (32, 38) unterschiedliche Höhen vorsieht, so festgelegt, dass die verschiedenen Werte des genannten Abstands kompensiert werden, um kugelförmige Elemente mit verschiedenen Höhen zu erhalten, welche die Ausrichtung bzw. Flucht der optischen Achsen (X, X1) der Komponenten gewährleisten.

2. Anordnung nach Anspruch 1, **dadurch gekennzeichnet, dass** wenigstens eine der optischen Komponenten eine optoelektronische Komponente (22) ist, und **dadurch**, dass der Träger (21) außerdem elektrische Leitungen (64) umfasst, die elektrisch durch Höcker bzw. kugelförmige Elemente (30) mit der optoelektronischen Komponente verbunden sind, wobei die kugelförmigen Elemente und die entsprechenden Befestigungseinrichtungen elektrisch leitend sind.

3. Anordnung nach Anspruch 2, **dadurch gekennzeichnet, dass** diese Leitungen in den Träger (21) integriert sind.

4. Anordnung nach Anspruch 2, **dadurch** gekenntzeichnet, dass diese Leitungen an der Oberfläche (S) des Trägers ausgebildet sind.

5. Verfahren zur Herstellung einer Anordnung von wenigstens zwei optischen Komponenten (22, 24), befestigt auf derselben Seite eines gemeinsamen Trägers (21), wobei jede der optischen Komponenten (22, 24) eine optische Achse (X, X1) hat und eine Hauptseite, die zu der genannten Achse parallel ist und von ihr durch einen bestimmten Abstand getrennt ist, wobei dieser Abstand für wenigstens eine erste der optischen Komponenten einen Wert aufweist, der sich von dem der anderen optischen Komponenten unterscheidet, die Anordnung so ist, dass die optischen Achsen der optischen Komponenten optisch ausgerichtet sind, und das Verfahren darin besteht:
• man erzeugt auf der Hauptseite von jeder optischen Komponente (22, 24) erste Befestigungseinrichtungen (34, 40) und auf der genannten Seite des gemeinsamen Trägers (21) zweite Befestigungseinrichtungen (32, 38),
• man erzeugt auf den zweiten Befestigungseinrichtungen (32, 38) Elemente (72, 74) aus schmelzbarem Material, wobei das schmelzbare Material die ersten und zweiten Befestigungseinrichtungen benetzen und mit ihnen eine Lötverbindung eingehen kann, aber die Umgebung der ersten und zweiten Befestigungseinrichtungen nicht benetzen kann,
• man befestigt die optischen Komponenten (22, 24) auf dem Träger (21), indem man die auf den zweiten Befestigungseinrichtungen (32, 38) erzeugten Elemente (72, 74) schmelzen lässt, wobei sie die Form von Kugeln (76, 78) annehmen, und dann diese Letzteren erstarren lässt, um jede zweite Befesiwigungseinrichtung (32, 38) durch ein kugelförmiges Element (30, 36) mit einem ersten Befestigungselement (34, 40) zu verbinden,
und darin, dass blei der Erzeugung der Elemente (72, 74) auf den zweiten Befestigungseinrichtungen (32, 38) die jedem der Komponenten entsprechenden Volumen der auf den zweiten Befestigungseinrichtungen erzeugten Elemente gewählt werden, um die Differenzen zwischen den Werten der genannten Abständen von einer Komponente zur anderen zu kompensieren, um automatisch beizutragen zu der Ausrichtung der optischen Achsen (X, X1) der optischen Komponenten bei ihrer Befestigung auf dem Träger, wobei das Verfahren **dadurch gekennzeichnet ist, dass** man die zweiten Befestigungseinrichtungen (32, 38) auf der genannten Seite des gemeinsamen Trägers (21) ausbildet, indem man diesen zweiten Befestigungseinrichtungen Größen verleiht, die dazu beitragen, die Differenzen zwischen den genannten Abständen von einer Komponente zur anderen zu kompensieren, wobei die Größendifferenzen der zweiten Einrichtungen (32, 38) und der darauf gebildeten Elemente (72, 74) festgelegt sind, um die optischen Komponenten (22, 24) auf dem Träger (21) durch kugelförmige Elemente (30, 36) verschiedener Höhen zu befestigen, welche die optische Ausrichtung bzw. Flucht der Komponenten gewährleisten.

6. Verfahren nach Anspruch 5, **dadurch gekennzeichnet, dass** die auf den zweiten Befestigungseinrichtungen (32, 38) gebildeten Elemente (72, 74) im Wesentlichen zylindrisch sind und alle die gleiche Dicke haben.

7. Verfahren nach Anspruch 6, **dadurch gekennzeichnet, dass** die im Wesentlichen zylindrischen Elemente (72, 74) simultan durch Photolithographie auf den beiden Befestigungseinrichtungen gebildet werden.

8. Verfahren nach einem der Ansprüche 5 bis 7, **dadurch gekennzeichnet, dass** das Material der Elemente (72, 74) ausgewählt wird aus der Gruppe, die Indium und Zinn-Blei-Legierung umfasst.

9. Verfahren nach einem der Ansprüche 5 bis 8, **dadurch gekennzeichnet, dass** wenigstens eine (22) der Komponenten optoelektronisch ist und die Befestigungseinrichtungen und die entsprechenden Elemente elektrische Leiter sind, und **dadurch**, dass man außerdem auf dem Träger (21) elektrische Leitungen (64) ausbildet, die dazu bestimmt sind, durch entsprechende kugelförmige Elemente (30) mit den optoelektronischen Komponenten verbunden zu werden.
